(19) Europäisches Patentamt
European Patent Office
Office européen des brevets

(11) **EP 4 571 340 B1**

(12) **EUROPEAN PATENT SPECIFICATION**

(45) Date of publication and mention
of the grant of the patent:
**06.05.2026 Bulletin 2026/19**

(51) International Patent Classification (IPC):
***G01R 31/3835*** (2019.01)   ***G01R 31/396*** (2019.01)
***B60L 58/10*** (2019.01)

(21) Application number: **23858545.9**

(22) Date of filing: **14.02.2023**

(52) Cooperative Patent Classification (CPC):
**G01R 31/3835; G01R 31/36; G01R 31/396**

(86) International application number:
**PCT/CN2023/075975**

(87) International publication number:
**WO 2024/045502 (07.03.2024 Gazette 2024/10)**

(54) **BATTERY VOLTAGE ACQUISITION FAULT EARLY WARNING METHOD AND SYSTEM**

FRÜHWARNVERFAHREN UND -SYSTEM FÜR BATTERIESPANNUNGSERFASSUNGSFEHLER

PROCÉDÉ ET SYSTÈME D'AVERTISSEMENT PRÉCOCE DE DÉFAUT D'ACQUISITION DE TENSION DE BATTERIE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **31.08.2022 CN 202211056283**

(43) Date of publication of application:
**18.06.2025 Bulletin 2025/25**

(73) Proprietor: **VOYAH Automotive Technology Co., Ltd.**
**Wuhan, Hubei 430109 (CN)**

(72) Inventors:
• **WANG, Yongshi**
**Wuhan, Hubei 430050 (CN)**
• **XIE, Hui**
**Wuhan, Hubei 430050 (CN)**
• **ZHU, Jinxin**
**Wuhan, Hubei 430050 (CN)**
• **HUANG, Min**
**Wuhan, Hubei 430050 (CN)**
• **LIU, Zhenyong**
**Wuhan, Hubei 430050 (CN)**
• **WANG, Junjun**
**Wuhan, Hubei 430050 (CN)**
• **LU, Fang**
**Wuhan, Hubei 430050 (CN)**
• **ZHANG, Shutao**
**Wuhan, Hubei 430050 (CN)**
• **LIU, Kai**
**Wuhan, Hubei 430050 (CN)**
• **SHEN, Jian**
**Wuhan, Hubei 430050 (CN)**

(74) Representative: **Boult Wade Tennant LLP**
**Salisbury Square House**
**8 Salisbury Square**
**London EC4Y 8AP (GB)**

(56) References cited:
WO-A1-2021/249269     CN-A- 106 324 385
CN-A- 108 571 998       CN-A- 108 931 725
CN-A- 108 931 725       CN-A- 109 613 435
CN-A- 109 709 485       CN-A- 112 319 308
CN-A- 112 319 308       CN-A- 114 415 054
CN-A- 114 660 472       CN-A- 114 660 475
CN-A- 114 779 104       CN-A- 115 480 171
JP-A- 2013 102 318      JP-A- 2017 070 024
JP-B2- 5 447 260        US-A1- 2013 214 791
US-A1- 2014 167 778     US-A1- 2014 176 148
US-A1- 2018 246 169     US-A1- 2019 285 669

## Description

### CROSS-REFERENCE TO RELATED APPLICATIONS

This application claims priority to Chinese application No. 202211056283.2, filed on August 31, 2022 and entitled "Fault Warning Method and System for Battery Voltage Acquisition".

### TECHNICAL FIELD

The present disclosure relates to the field of battery safety and, in particular, to a fault warning method and system for battery voltage acquisition.

### BACKGROUND

Safety of batteries has become an increasing social concern in recent years, and as a battery nanny or a battery manager, a battery management system, BMS, is mainly used for intelligent management and maintenance of various battery units, preventing over-charging and over-discharging of the batteries, extending the service life of the batteries, and monitoring status of the batteries. If battery voltage information acquired by the battery management system, BMS, is incorrect, the battery management system will be seriously affected in terms of its normal operation, and therefore the batteries would be under safety hazards.

When determining that there is a fault in voltage sampling of a battery, generally, the existing battery management system, BMS, only judges a value of the voltage sampling of the battery that is lost or exceeds a range. Authenticity cannot be determined for the value within the range and it is impossible to know whether there is abnormal voltage sampling data. Prior art document CN108931725A discloses battery voltage monitoring for a battery stack with plural cells, involving measuring the total stack voltage, measuring the cell voltages, and comparing the total stack voltage to the sum of the cell voltages to indicate a fault in a battery cell and, particularly, in the voltage sensing circuitry itself.

### SUMMARY

The present disclosure provides a fault warning method and system for battery voltage acquisition, according to which an abnormal battery cell can be timely obtained and a sampling fault warning signal can be issued, to enable a battery to be in a safe operation state.

In a first aspect of the present disclosure, a fault warning method for battery voltage acquisition is provided, which includes steps of: acquiring, within a preset monitoring duration, a total voltage of a battery system at each frame of time and acquiring an effective battery cell voltage of each battery cell; calculating a number of frames with abnormal voltage data based on the preset monitoring duration, the total voltage of the battery system and each effective battery cell voltage; calculating a total number of frames in the preset monitoring duration, and calculating a ratio of the number of frames with abnormal voltage data to the total number of frames, and if the ratio is greater than or equal to a preset proportion threshold, identifying an abnormal battery cell from respective battery cells and issuing a sampling fault warning signal.

In a second aspect of the present disclosure, a fault warning system for battery voltage acquisition is provided, including: a voltage acquisition module, configured to acquire, within a preset monitoring duration, a total voltage of a battery system at each frame of time and acquire an effective battery cell voltage of each battery cell; a module for acquiring a number of frames with abnormality, connected with the voltage acquisition module in a communication way and configured to calculate a number of frames with abnormal voltage data based on the preset monitoring duration, the total voltage of the battery system and each effective battery cell voltage; an abnormal battery cell module, connected in a communication way with the voltage acquisition module and the module for acquiring a number of frames with abnormality, and configured to: calculate a total number of frames in the preset monitoring duration, and calculate a ratio of the number of frames with abnormal voltage data to the total number of frames, and if the ratio is greater than or equal to a preset proportion threshold, identify an abnormal battery cell from respective battery cells and issue a sampling fault warning signal.

### BRIEF DESCRIPTION OF DRAWINGS

FIG. 1 shows an exemplary flowchart of a fault warning method for battery voltage acquisition according to some embodiments of the present disclosure.

FIG. 2 shows an exemplary flowchart of a fault warning method for battery voltage acquisition according to other embodiments of the present disclosure.

FIG. 3 shows an exemplary flowchart of a fault warning method for battery voltage acquisition according to yet other embodiments of the present disclosure.

FIG. 4 shows an exemplary structural diagram of a fault warning system for battery voltage acquisition according to some embodiments of the present disclosure.

Description of drawings:

100: fault warning system for battery voltage acquisition; 110: voltage acquisition module; 120: module for acquiring a number of frames with abnormality; 130: abnormal battery cell module.

## DESCRIPTION OF EMBODIMENTS

Now, with detailed reference to specific embodiments of the present disclosure, examples of the present disclosure are illustrated in the drawings. Although the present disclosure will be described in conjunction with specific embodiments, it will be understood that it is not intended to limit the present disclosure to the embodiments. On the contrary, it is intended to cover changes and modifications included within the scope of the present disclosure as defined by the appended claims. It should be noted that the method steps described here can be implemented by any functional block or functional arrangement, and any functional block or functional arrangement can be implemented as a physical entity or a logical entity, or a combination of both.

In order to enable those skilled in the art to better understand the present disclosure, further detailed explanations will be made hereunder to the present disclosure in conjunction with the drawings and the specific implementations.

Please be noted that examples to be introduced below are only specific examples and are not intended to limit embodiments of the present disclosure to the following specific steps, values, conditions, data, order, etc. Those skilled in the art, by reading the description, can use concepts of the present disclosure to construct more embodiments not mentioned therein.

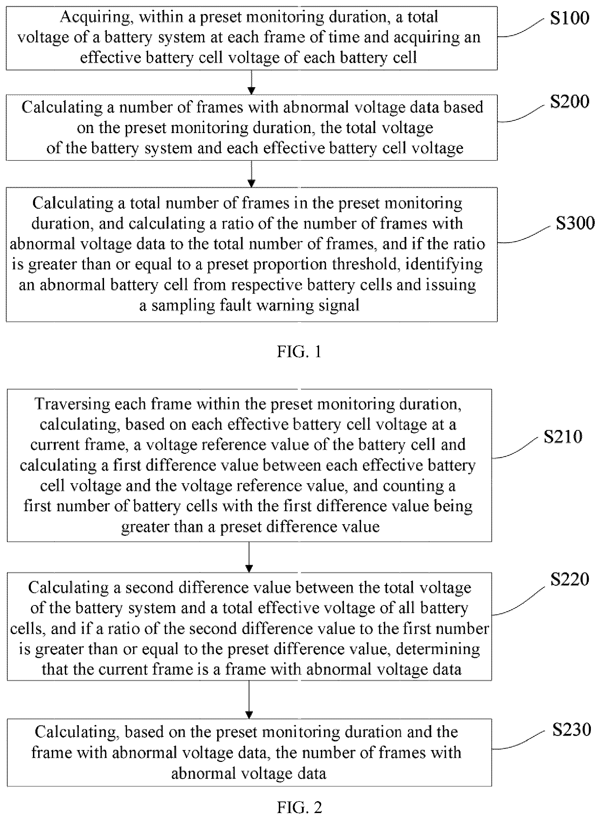

As shown in FIG. 1, an embodiment of the present disclosure provides a fault warning method for battery voltage acquisition, which includes the following steps S100 to S300.

S100, acquiring, within a preset monitoring duration, a total voltage of a battery system at each frame of time and acquiring an effective battery cell voltage of each battery cell; where a BMS acquires the voltage of each individual battery cell, while simultaneously directly acquiring the total voltage of the battery system between a total positive terminal and a total negative terminal of the battery system.

S200, calculating a number of frames with abnormal voltage data based on the preset monitoring duration, the total voltage of the battery system and each effective battery cell voltage; where the preset monitoring duration is a duration for monitoring data, in order to eliminate accuracy fluctuations caused by a small amount of monitoring data, the preset monitoring duration of the vehicle on the same day is usually greater than a certain threshold.

S300, calculating a total number of frames in the preset monitoring duration, and calculating a ratio of the number of frames with abnormal voltage data to the total number of frames, and if the ratio is greater than or equal to a preset proportion threshold, identifying an abnormal battery cell from respective battery cells and issuing a sampling fault warning signal.

In some embodiments, for example, if the preset monitoring duration is 10 minutes and a data monitoring frequency is 10 seconds per frame, the total number of frames in the preset monitoring duration is the product of the preset monitoring duration and the data monitoring frequency, totaling 60 frames.

In some embodiments, when determining that there is a fault in voltage sampling of a battery, generally, the existing battery management system, BMS, only judges a value of the voltage sampling of the battery that is lost or exceeds a range. Authenticity cannot be determined for the value within the range and it is impossible to know whether there is abnormal voltage sampling data. Therefore, in the present disclosure, firstly, a total voltage of a battery system at each frame of time is acquired within a preset monitoring duration, and an effective battery cell voltage of each battery cell is acquired; a number of frames with abnormal voltage data is calculated based on the preset monitoring duration, the total voltage of the battery system and each effective battery cell voltage; a total number of frames in the preset monitoring duration is calculated, and a ratio of the number of frames with abnormal voltage data to the total number of frames is calculated, and if the ratio is greater than or equal to a preset proportion threshold, an abnormal battery cell is identified from respective battery cells and a sampling fault warning signal is issued. Therefore, it is possible to timely identify an abnormal battery cell and issue a sampling fault warning signal, to enable a battery to be in a safe operation state.

Referring to FIG. 2, in other embodiments of the present disclosure, the step of "S200, calculating a number of frames with abnormal voltage data based on the preset monitoring duration, the total voltage of the battery system and each effective battery cell voltage" specifically includes the following steps:

S210, traversing each frame within the preset monitoring duration, calculating, based on each effective battery cell voltage at a current frame, a voltage reference value of the battery cell and calculating a first difference value between each effective battery cell voltage and the voltage reference value, and counting a first number of battery cells with the first difference value being greater than a preset difference value;

S220, calculating a second difference value between the total voltage of the battery system and a total effective voltage of all battery cells, and if a ratio of the second difference value to the first number is greater than or equal to the preset difference value, determining that the current frame is a frame with abnormal voltage data;

S230, calculating, based on the preset monitoring duration and the frame with abnormal voltage data, the number of frames with abnormal voltage data.

In some embodiments, if the preset monitoring duration is 10 minutes and a data monitoring frequency is 10 seconds per frame, the total number of frames in the preset monitoring duration is 60 frames. When traversing the 60 frames within the 10 minutes, if there is an abnormality in voltage data at a current frame traversed, it is determined that the current frame is a frame with abnormal voltage data. For example, if the first frame, the third frame, the fifth frame, the tenth frame, and the 50-th frame traversed within 10 minutes all are frames with abnormal voltage data, the number of frames with abnormal voltage data accounts to 5 frames.

In other embodiments of the present disclosure, the step of "S210, traversing each frame within the preset monitoring duration, calculating, based on each effective battery cell voltage at a current frame, a voltage reference value of the battery cell and calculating a first difference value between each effective battery cell voltage and the voltage reference value, and counting a first number of battery cells with the first difference value being greater than a preset difference value" specifically includes a step of:

traversing each frame within the preset monitoring duration, calculating, based on each effective battery cell voltage at a current frame, a median voltage of all effective battery cell voltages and calculating a median difference between each effective battery cell voltage and the median voltage, and counting the first number of battery cells with the median difference being greater than the preset difference value; or

traversing each frame within the preset monitoring duration, calculating, based on each effective battery cell voltage at a current frame, an average voltage of all effective battery cell voltages and calculating an average difference between each effective battery cell voltage and the average voltage, and counting the first number of battery cells with the average difference being greater than the preset difference value.

In some embodiments, the definition of the voltage reference value can be divided into two situations: a median voltage and an average voltage. The preset difference value can be set to 0.2V, and the preset difference can be adjusted according to the performance of the big data production environment until stabilization, controlling the false alarm rate and the missed alarm rate of the warning at a certain level. Median difference: a difference between each data and a median of a set of data. Average difference: a difference between each data and an average of a set of data. False alarm rate: a ratio of the number of vehicles with inaccurate warnings to the total number of vehicles with warnings. Missed alarm rate: the ratio of the number of problematic vehicles unalarmed to the total number of problematic vehicles in the market.

In other embodiments of the present disclosure, the step of "S220, calculating a second difference value between the total voltage of the battery system and a total effective voltage of all battery cells, and if a ratio of the second difference value to the first number is greater than or equal to the preset difference value, determining that the current frame is a frame with abnormal voltage data" specifically includes steps of:

calculating, based on the total voltage $\text{Volt}_{total}$ of the battery system and the total effective voltage $\text{Volt1}_{total}$ of all the battery cells, the second difference value $\text{volt}_{off}$ between the total voltage $\text{Volt}_{total}$ of the battery system and the total effective voltage $\text{Volt1}_{total}$ of all the battery cells:

$$\text{volt}_{off} = \text{Volt}_{total} - \text{Volt1}_{total} = \text{Volt}_{total} - \sum_{i=1}^{n} \text{Cell}_i \qquad \text{equation (1)}$$

if a ratio of the second difference value $\text{volt}_{off}$ to the first number N is greater than or equal to the preset difference value $\text{volt}_{thr}$:

$$\frac{\text{volt}_{off}}{N} \geq \text{volt}_{thr} \qquad \text{equation (2),}$$

determining that the current frame is a frame with abnormal voltage data;

where in equation (1), $\text{Cell}_i$ is a voltage of an i-th battery cell, and n is a total number of the battery cells.

In other embodiments of the present disclosure, the step of "S300, calculating a total number of frames in the preset monitoring duration, and calculating a ratio of the number of frames with abnormal voltage data to the total number of frames, and if the ratio is greater than or equal to a preset proportion threshold, identifying an abnormal battery cell from respective battery cells" specifically includes a step of:

calculating the total number of frames in the preset monitoring duration, and calculating the ratio of the number of frames with abnormal voltage data to the total number of frames, and if the ratio is greater than or equal to the preset proportion threshold, determining, from the respective battery cells, that a battery cell, with a highest occurrence number of a maximum median difference or a maximum average difference at a single frame of time within the preset monitoring duration, is the abnormal battery cell.

In some embodiments, the preset proportion threshold can be set to 10%, and the threshold can be adjusted according to the performance of the big data production environment until stabilization, controlling the false alarm rate and missed alarm rate of the warning at a certain level.

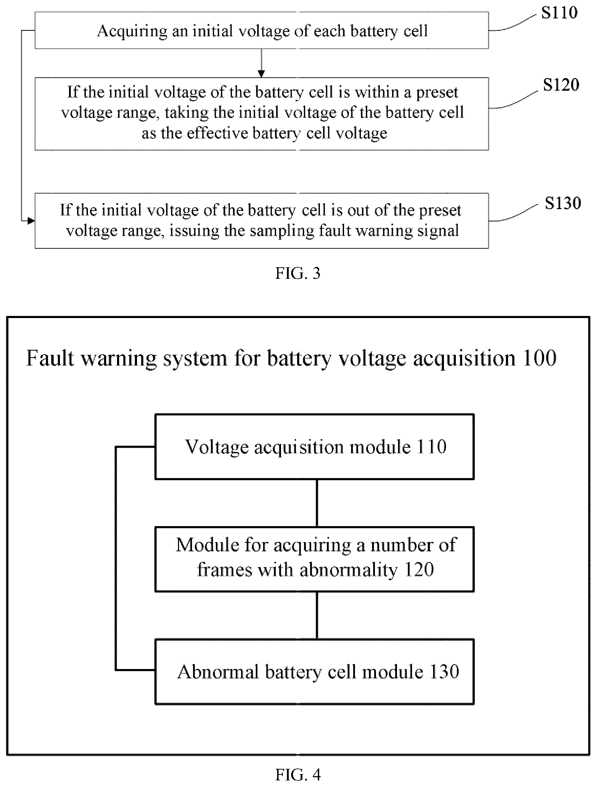

Referring to FIG. 3, in other embodiments of the present disclosure, the step of "acquiring an effective battery cell voltage of each battery cell" in S100 specifically includes the following steps:

S110, acquiring an initial voltage of each battery cell;
S120, if the initial voltage of the battery cell is within a preset voltage range, taking the initial voltage of the battery cell as the effective battery cell voltage;
S130, if the initial voltage of the battery cell is out of the preset voltage range, issuing the sampling fault warning signal.

In some embodiments, since a reasonable effective range of a voltage for a single battery cell is generally (0V, 5V), the preset voltage range is (0V, 5V). Therefore, generally, the voltage within 0-5V is the effective voltage of the battery cell. If the voltage of the single battery cell is 0V or larger than or equal to 5V, a direct determination would be that there is a fault in the voltage acquisition.

The present disclosure provides a fault warning method for battery voltage acquisition:

1. acquiring, within a preset monitoring duration, a total voltage of a battery system at each frame of time and acquiring an initial voltage of each battery cell; if the initial voltage of the battery cell is within a preset voltage range, taking the initial voltage of the battery cell as the effective battery cell voltage;

2. traversing each frame within the preset monitoring duration, calculating, based on each effective battery cell voltage at a current frame, a voltage reference value of the battery cell and calculating a first difference value between each effective battery cell voltage and the voltage reference value, and counting a first number N of battery cells with the first difference value being greater than a preset difference value;

3. calculating, based on the total voltage $\text{Volt}_{total}$ of the battery system and the total effective voltage $\text{Volt1}_{total}$ of all the battery cells, the second difference value $\text{volt}_{off}$ between the total voltage $\text{Volt}_{total}$ of the battery system and the total effective voltage $\text{Volt1}_{total}$ of all the battery cells:

$$\text{volt}_{off} = \text{Volt}_{total} - \text{Volt1}_{total} = \text{Volt}_{total} - \sum_{i=1}^{n} \text{Cell}_i$$
;

4. if a ratio of the second difference value volt to the first number N is greater than or equal to the preset difference value $\text{volt}_{thr}$: $\dfrac{\text{volt}_{off}}{N} \geq \text{volt}_{thr}$, determining that the current frame is a frame with abnormal voltage data;

5. calculating the total number of frames in the preset monitoring duration, and calculating the ratio of the number of frames with abnormal voltage data to the total number of frames, and if the ratio is greater than or equal to the preset proportion threshold, determining, from the respective battery cells, that a battery cell, with a highest occurrence number of a maximum median difference or a maximum average difference at a single frame of time within the preset monitoring duration, is the abnormal battery cell.

Referring to FIG. 4, an embodiment of the present disclosure further provides a fault warning system for battery voltage acquisition 100, which may include: a voltage acquisition module 110, a module for acquiring a number of frames with abnormality 120, and an abnormal battery cell module 130; where the voltage acquisition module 110 is configured to acquire, within a preset monitoring duration, a total voltage of a battery system at each frame of time and acquire an effective battery cell voltage of each battery cell; the module for acquiring a number of frames with abnormality 120 is connected with the voltage acquisition module 110 in a communication way and configured to calculate a number of frames with abnormal voltage data based on the preset monitoring duration, the total voltage of the battery system and each effective battery cell voltage; and the abnormal battery cell module 130 is connected in a communication way with the voltage acquisition module 110 and the module for acquiring a number of frames with abnormality 120, and is configured to calculate a total number of frames in the preset monitoring duration, and calculate a ratio of the number of frames with abnormal voltage data to the total number of frames, and if the ratio is greater than or equal to a preset proportion threshold, identify an abnormal battery cell from respective battery cells and issue a sampling fault warning signal.

The module for acquiring a number of frames with abnormality 120 is configured to traverse each frame within the preset monitoring duration, calculate, based on each effective battery cell voltage at a current frame, a voltage reference value of the battery cell and calculate a first difference value between each effective battery cell voltage and the voltage reference value, and count a first number of battery cells with the first difference value being greater than a preset difference value; calculate a second difference value between the total voltage of the battery system and a total effective voltage of all battery cells, and if a ratio of the second difference value to the first number is greater than or equal to the preset difference value, determine that the current frame is a frame with abnormal voltage data; calculate, based on the preset monitoring duration and the frame with abnormal voltage data, the number of frames with abnormal voltage data.

The abnormal battery cell module 130 is configured to calculate the total number of frames in the preset monitoring duration, and calculate the ratio of the number of frames with abnormal voltage data to the total number of frames, and if the ratio is greater than or equal to the preset proportion threshold, determine, from the respective battery cells, that a battery cell, with a highest occurrence number of a maximum median difference or a maximum average difference at a single frame of time within the preset monitoring duration, is the abnormal battery cell.

Therefore, in the present disclosure, firstly, a total voltage of a battery system at each frame of time is acquired within a preset monitoring duration, and an effective battery cell voltage of each battery cell is acquired; a number of frames with abnormal voltage data is calculated based on the preset monitoring duration, the total voltage of the battery system and each effective battery cell voltage; a total number of frames in the preset monitoring duration is calculated, and a ratio of the number of frames with abnormal voltage data to the total number of frames is calculated, and if the ratio is greater than or equal to a preset proportion threshold, an abnormal battery cell is identified from respective battery cells and a sampling fault warning signal is issued. Therefore, an abnormal battery cell can be timely obtained and a sampling fault warning signal can be issued, to enable a battery to be in a safe operation state.

Specifically, this embodiment corresponds to the above method embodiments, and the functions of each module have been described in detail in the corresponding method embodiments, which will not be repeated again.

Based on the same inventive concept, an embodiment of the present disclosure further provides a computer-readable storage medium in which a computer program is stored. When the computer program is executed by a processor, all or part of the method steps of the above method are implemented.

The present disclosure implements all or part of the processes in the above method, which can also be accomplished by instructing relevant hardware through a computer program. The computer program can be stored in a computer-readable storage medium, and the computer program, when executed by a processor, implements the steps of the various method embodiments described above. The computer program includes computer program codes which can be in a form of source codes, object codes or executable files, or in some intermediate forms. The computer-readable medium can include any entity or apparatus capable of carrying computer program codes, a recording medium, a USB flash drive, a mobile hard disk drive, a magnetic disk, an optical disk, a computer memory, a read-only memory (ROM), a random access memory (RAM), an electrical carrier signal, a telecommunications signal, and a software distribution medium. It should be noted that content contained in the computer-readable medium can be appropriately added or removed according to requirements of legislation and patent practice within the jurisdiction. For example, in some jurisdictions, according to the legislation and the patent practice, the computer-readable medium does not include electrical carrier signals and telecommunications signals.

Based on the same inventive concept, an embodiment of the present disclosure further provides an electronic device which includes a memory and a processor, where the memory stores a computer program running in the processor, and the processor implements all or part of the method steps in the above method when executing the computer program.

The processor can be a central processing unit (CPU), as well as other general-purpose processors, a digital signal processor (DSP), an application specific integrated circuit (ASIC), a field-programmable gate array (FPGA) or other programmable logic devices, a discrete gate or a transistor logic device, a discrete hardware component, etc. A general-purpose processor can be a microprocessor or any conventional processor, etc. The processor is a control center of a computer device, and connects various parts of the entire computer device through various interfaces and circuits.

The memory can be used to store a computer program and/or module, and the processor achieves various functions of the computer device by running or executing the computer program and/or module stored in the memory, as well as calling data stored in the memory. The memory may mainly include a program storage area and a data storage area, where the program storage area can store an operating system and at least one application program required for a function (such as a sound playing function, an image playing function, etc.); and the data storage area may store data created based on the use of the mobile phone (such as audio data, video data, etc.). In addition, the memory may include a high-speed random access memory, as well as a non-volatile memory such as a hard drive, a memory, a plug-in hard drive, a smart media card (SMC), a secure digital (SD) card, a flash card, at least one disk storage device, a flash device, or other volatile solid-state storage devices.

Those skilled in the art should understand that the embodiments of the present disclosure can provide the method, the system, the server, or the computer program product. Therefore, the present disclosure may take a form of a fully hardware embodiment, a fully software embodiment, or a combination of software and hardware embodiments. Moreover, the present disclosure may take a form of a computer program product implemented in one or more computer usable storage media (including but not limited to disk storage and optical storage) containing computer usable program codes.

The present disclosure is described with reference to the flowcharts and/or the block diagrams of the method, the device (system), the server, and the computer program product according to the embodiments of the present disclosure. It should be understood that each process and/or block in the flowchart and/or the block diagram, as well as a combination of the process and/or the block in the flowchart and/or the block diagram, can be implemented by computer program instructions. These computer program instructions can be provided to a processor of a general-purpose computer, a specialized computer, an embedded processor, or other programmable data processing devices to generate a machine, such that the instructions executed by the processor of the computer or the other programmable data processing device generate an apparatus for implementing functions specified in one or more processes of the flowchart and/or one or more blocks of the block diagram.

These computer program instructions can also be stored in a computer-readable memory that may guide a computer or other programmable data processing devices to operate in a specific manner, causing instructions stored in the computer-readable memory to produce a manufactured product including instruction devices that implement the functions specified in a flowchart or multiple flowcharts and/or a block or multiple blocks of the block diagram.

These computer program instructions can also be loaded into a computer or other programmable data processing devices, enabling a series of operational steps to be performed in the computer or the other programmable data processing devices to generate computer implemented processing. Therefore, the instructions executed in the computer or the other programmable data processing devices provide steps for implementing the functions specified in one or more processes in the flowchart and/or one or more blocks in the block diagram.

Compared with the prior art, the present disclosure is advantageous in terms of: firstly, acquiring, within a preset monitoring duration, a total voltage of a battery system at each frame of time and acquiring an effective battery cell voltage of each battery cell; calculating a number of frames with abnormal voltage data based on the preset monitoring duration, the total voltage of the battery system and each effective battery cell voltage; calculating a total number of frames in the preset monitoring duration, and calculating a ratio of the number of frames with abnormal voltage data to the total number of frames, and if the ratio is greater than or equal to a preset proportion threshold, identifying an abnormal battery cell from respective battery cells and issuing a sampling fault warning signal. Therefore, an abnormal battery cell can be timely obtained and a sampling fault warning signal can be issued, to enable a battery to be in a safe operation state.

Obviously, those skilled in the art can make various modifications and variations to the present disclosure without departing from the scope of the present disclosure. In this way, if the modifications and variations of the present disclosure fall within the scope of the invention as defined by the claims, the present disclosure is also intended to include the modifications and variations.

**Claims**

1.  A fault warning method for battery voltage acquisition, comprising steps of:

    acquiring (S100), within a preset monitoring duration, a total voltage of a battery system at each frame of time and acquiring an effective battery cell voltage of each battery cell;
    calculating (S200) a number of frames with abnormal voltage data based on the preset monitoring duration, the total voltage of the battery system and each effective battery cell voltage;
    calculating (S300) a total number of frames in the preset monitoring duration, and calculating a ratio of the number of frames with abnormal voltage data to the total number of frames, and if the ratio is greater than or equal to a preset proportion threshold, identifying an abnormal battery cell from respective battery cells and issuing a sampling fault warning signal.

2.  The fault warning method for battery voltage acquisition according to claim 1, wherein the step of "calculating (S200) a number of frames with abnormal voltage data based on the preset monitoring duration, the total voltage of the battery system and each effective battery cell voltage" comprises steps of:

    traversing (S210) each frame within the preset monitoring duration, calculating, based on each effective battery cell voltage at a current frame, a voltage reference value of the battery cell and calculating a first difference value between each effective battery cell voltage and the voltage reference value, and counting a first number of battery cells with the first difference value being greater than a preset difference value;

calculating (S220) a second difference value between the total voltage of the battery system and a total effective voltage of all battery cells, and if a ratio of the second difference value to the first number is greater than or equal to the preset difference value, determining that the current frame is a frame with abnormal voltage data;

calculating (S230), based on the preset monitoring duration and the frame with abnormal voltage data, the number of frames with abnormal voltage data.

3. The fault warning method for battery voltage acquisition according to claim 2, wherein the first difference value comprises a median difference or a voltage average, and the step of "calculating (S210), based on each effective battery cell voltage at a current frame, a voltage reference value of the battery cell and calculating a first difference value between each effective battery cell voltage and the voltage reference value, and counting a first number of battery cells with the first difference value being greater than a preset difference value" comprises a step of:

calculating, based on each effective battery cell voltage at the current frame, a median voltage of all effective battery cell voltages and calculating a median difference between each effective battery cell voltage and the median voltage, and counting the first number of battery cells with the median difference being greater than the preset difference value; or

calculating, based on each effective battery cell voltage at the current frame, an average voltage of all effective battery cell voltages and calculating an average difference between each effective battery cell voltage and the average voltage, and counting the first number of battery cells with the average difference being greater than the preset difference value.

4. The fault warning method for battery voltage acquisition according to claim 3, wherein the step of "calculating (S220) a second difference value between the total voltage of the battery system and a total effective voltage of all battery cells, and if a ratio of the second difference value to the first number is greater than or equal to the preset difference value, determining that the current frame is a frame with abnormal voltage data" comprises steps of:

calculating, based on the total voltage $Volt_{total}$ of the battery system and the total effective voltage $Volt1_{total}$ of all the battery cells, the second difference value $volt_{off}$ between the total voltage $Volt_{total}$ of the battery system and the total effective voltage $Volt1_{total}$ of all the battery cells:

$$\mathrm{volt_{off}} = \mathrm{Volt_{total}} - \mathrm{Volt1_{total}} = \mathrm{Volt_{total}} - \sum_{i=1}^{n} \mathrm{Cell_i} \qquad \text{equation (1)}$$

if a ratio of the second difference value $volt_{off}$ to the first number N is greater than or equal to the preset difference value $volt_{thr}$ :

$$\frac{\mathrm{volt_{off}}}{\mathrm{N}} \geq \mathrm{volt}_{thr} \qquad \text{equation (2),}$$

determining that the current frame is a frame with abnormal voltage data;

wherein in equation (1), $Cell_i$ is a voltage of an i-th battery cell, and n is a total number of the battery cells.

5. The fault warning method for battery voltage acquisition according to claim 3, wherein the step of "calculating (S300) a total number of frames in the preset monitoring duration, and calculating a ratio of the number of frames with abnormal voltage data to the total number of frames, and if the ratio is greater than or equal to a preset proportion threshold, identifying an abnormal battery cell from respective battery cells" comprises a step of:

calculating the total number of frames in the preset monitoring duration, and calculating the ratio of the number of frames with abnormal voltage data to the total number of frames, and if the ratio is greater than or equal to the preset proportion threshold, determining, from the respective battery cells, that a battery cell, with a highest occurrence number of a maximum median difference or a maximum average difference at a single frame of time within the preset monitoring duration, is the abnormal battery cell.

6. The fault warning method for battery voltage acquisition according to claim 1, wherein the step of "acquiring (S100) an effective battery cell voltage of each battery cell" comprises steps of:

acquiring (S110) an initial voltage of each battery cell;

if the initial voltage of the battery cell is within a preset voltage range, taking (S120) the initial voltage of the battery cell as the effective battery cell voltage;

if the initial voltage of the battery cell is out of the preset voltage range, issuing (S130) the sampling fault warning signal.

7. The fault warning method for battery voltage acquisition according to claim 2, wherein the preset difference value is set to 0.2V and the preset proportion threshold is set to 10%.

8. A fault warning system for battery voltage acquisition (100), comprising:

a voltage acquisition module (110), configured to acquire, within a preset monitoring duration, a total voltage of a battery system at each frame of time and acquire an effective battery cell voltage of each battery cell;

a module for acquiring a number of frames with abnormality (120), connected with the voltage acquisition module (110) in a communication way and configured to calculate a number of frames with abnormal voltage data based on the preset monitoring duration, the total voltage of the battery system and each effective battery cell voltage;

an abnormal battery cell module (130), connected in a communication way with the voltage acquisition module (110) and the module for acquiring a number of frames with abnormality (120), and configured to: calculate a total number of frames in the preset monitoring duration, and calculate a ratio of the number of frames with abnormal voltage data to the total number of frames, and if the ratio is greater than or equal to a preset proportion threshold, identify an abnormal battery cell from respective battery cells and issue a sampling fault warning signal.

9. The fault warning system for battery voltage acquisition (100) according to claim 8, wherein the module for acquiring a number of frames with abnormality (120) is configured to: traverse each frame within the preset monitoring duration, calculate, based on each effective battery cell voltage at a current frame, a voltage reference value of the battery cell and calculate a first difference value between each effective battery cell voltage and the voltage reference value, and count a first number of battery cells with the first difference value being greater than a preset difference value; calculate a second difference value between the total voltage of the battery system and a total effective voltage of all battery cells, and if a ratio of the second difference value to the first number is greater than or equal to the preset difference value, determine that the current frame is a frame with abnormal voltage data; calculate, based on the preset monitoring duration and the frame with abnormal voltage data, the number of frames with abnormal voltage data.

10. The fault warning system for battery voltage acquisition (100) according to claim 9, wherein the first difference value comprises a median difference or a voltage average, and the module for acquiring a number of frames with abnormality (120) is further configured to:

calculate, based on each effective battery cell voltage at the current frame, a median voltage of all effective battery cell voltages and calculate a median difference between each effective battery cell voltage and the median voltage, and count the first number of battery cells with the median difference being greater than the preset difference value; or

calculate, based on each effective battery cell voltage at the current frame, an average voltage of all effective battery cell voltages and calculate an average difference between each effective battery cell voltage and the average voltage, and count the first number of battery cells with the average difference being greater than the preset difference value.

11. The fault warning system for battery voltage acquisition (100) according to claim 10, wherein the module for acquiring a number of frames with abnormality (120) is further configured to:

calculate, based on the total voltage $Volt_{total}$ of the battery system and the total effective voltage $Volt1_{total}$ of all the battery cells, the second difference value $volt_{off}$ between the total voltage $Volt_{total}$ of the battery system and the total effective voltage $Volt1_{total}$ of all the battery cells:

$$volt_{off} = Volt_{total} - Volt1_{total} = Volt_{total} - \sum_{i=1}^{n} Cell_i$$

equation (1)

if a ratio of the second difference value $volt_{off}$ to the first number N is greater than or equal to the preset difference value $volt_{thr}$:

$$\frac{\text{volt}_{\text{off}}}{N} \geq \text{volt}_{thr} \qquad \text{equation (2),}$$

determine that the current frame is a frame with abnormal voltage data;
wherein in equation (1), $\text{Cell}_i$ is a voltage of an i-th battery cell, and n is a total number of the battery cells.

12. The fault warning system for battery voltage acquisition (100) according to claim 10, wherein the abnormal battery cell module (130) is configured to: calculate the total number of frames in the preset monitoring duration, and calculate the ratio of the number of frames with abnormal voltage data to the total number of frames, and if the ratio is greater than or equal to the preset proportion threshold, determine, from the respective battery cells, that a battery cell, with a highest occurrence number of a maximum median difference or a maximum average difference at a single frame of time within the preset monitoring duration, is the abnormal battery cell.

13. The fault warning system for battery voltage acquisition (100) according to claim 8, wherein the voltage acquisition module (110) is further configured to:

acquire an initial voltage of each battery cell;
if the initial voltage of the battery cell is within a preset voltage range, take the initial voltage of the battery cell as the effective battery cell voltage;
if the initial voltage of the battery cell is out of the preset voltage range, issue the sampling fault warning signal.

14. The fault warning system for battery voltage acquisition (100) according to claim 9, wherein the preset difference value is set to 0.2V and the preset proportion threshold is set to 10%.

15. A computer-readable storage medium, storing a computer program which, when executed by a processor, enables the processor to implement the method according to any one of claims 1 to 7.

**Patentansprüche**

1. Fehlerwarnverfahren für Batteriespannungserfassung, das die folgenden Schritten umfasst:

Erfassen (S100) innerhalb einer voreingestellten Überwachungsdauer einer Gesamtspannung eines Batteriesystems in jedem Zeitrahmen und Erfassen einer effektiven Batteriezellenspannung jeder Batteriezelle;
Berechnen (S200) einer Anzahl von Rahmen mit abnormalen Spannungsdaten basierend auf der voreingestellten Überwachungsdauer, der Gesamtspannung des Batteriesystems und jeder effektiven Batteriezellenspannung;
Berechnen (S300) einer Gesamtzahl von Rahmen in der voreingestellten Überwachungsdauer und Berechnen eines Verhältnisses der Anzahl von Rahmen mit anormalen Spannungsdaten zur Gesamtzahl von Rahmen; und wenn das Verhältnis größer oder gleich einem voreingestellten Verhältnisschwellenwert ist, Identifizieren einer anormalen Batteriezelle aus jeweiligen Batteriezellen und Ausgeben eines Abtastfehlerwarnsignals.

2. Fehlerwarnverfahren für Batteriespannungserfassung nach Anspruch 1, wobei der Schritt "Berechnen (S200) einer Anzahl von Rahmen mit abnormalen Spannungsdaten basierend auf der voreingestellten Überwachungsdauer, der Gesamtspannung des Batteriesystems und der effektiven Spannung jeder Batteriezelle" die folgenden Schritte umfasst:

Durchlaufen (S210) jedes Rahmens innerhalb der voreingestellten Überwachungsdauer, Berechnen, basierend auf der effektiven Batteriezellenspannung in einem aktuellen Rahmen, eines Spannungsreferenzwerts der Batteriezelle und Berechnen eines ersten Differenzwerts zwischen der effektiven Batteriezellenspannung und dem Spannungsreferenzwert sowie Zählen einer ersten Anzahl von Batteriezellen, deren erster Differenzwert größer als ein voreingestellter Differenzwert ist;
Berechnen (S220) eines zweiten Differenzwertes zwischen der Gesamtspannung des Batteriesystems und einer effektiven Gesamtspannung aller Batteriezellen; und wenn ein Verhältnis des zweiten Differenzwertes zum ersten Wert größer oder gleich dem voreingestellten Differenzwert ist, Bestimmen, dass der aktuelle Rahmen ein Rahmen mit anormalen Spannungsdaten ist;
Berechnen (S230), basierend auf der voreingestellten Überwachungsdauer und dem Rahmen mit anormalen Spannungsdaten, der Anzahl von Rahmen mit anormalen Spannungsdaten.

3. Fehlerwarnverfahren für Batteriespannungserfassung nach Anspruch 2, wobei der erste Differenzwert eine Mediandifferenz oder einen Spannungsdurchschnitt umfasst, und der Schritt "Berechnen (S210) eines Spannungsreferenzwerts der Batteriezelle basierend auf der effektiven Batteriezellenspannung in einem aktuellen Rahmen und Berechnen eines ersten Differenzwerts zwischen der jeweiligen effektiven Batteriezellenspannung und dem Spannungsreferenzwert sowie Zählen einer ersten Anzahl von Batteriezellen, deren erster Differenzwert größer als ein voreingestellter Differenzwert ist", die folgenden Schritte umfasst:

Berechnen, basierend auf der jeweiligen effektiven Batteriezellenspannung im aktuellen Rahmen, einer Medianspannung aller effektiven Batteriezellenspannungen und Berechnen einer Mediandifferenz zwischen jeder effektiven Batteriezellenspannung und der Medianspannung und Zählen der ersten Anzahl von Batteriezellen, deren Mediandifferenz größer als der voreingestellte Differenzwert ist; oder
Berechnen, basierend auf der jeweiligen effektiven Batteriezellenspannung im aktuellen Rahmen, einer Durchschnittsspannung aller effektiven Batteriezellenspannungen und Berechnen einer Durchschnittsdifferenz zwischen jeder effektiven Batteriezellenspannung und der Durchschnittsspannung sowie Zählen der ersten Anzahl von Batteriezellen, deren Durchschnittsdifferenz größer als der voreingestellte Differenzwert ist.

4. Fehlerwarnverfahren für Batteriespannungserfassung nach Anspruch 3, wobei der Schritt "Berechnen (S220) eines zweiten Differenzwertes zwischen der Gesamtspannung des Batteriesystems und einer effektiven Gesamtspannung aller Batteriezellen; und wenn ein Verhältnis des zweiten Differenzwertes zum ersten Wert größer oder gleich dem voreingestellten Differenzwert ist, Bestimmen, dass der aktuelle Rahmen ein Rahmen mit anormalen Spannungsdaten ist" die folgenden Schritte umfasst:

Berechnen, basierend auf der Gesamtspannung $Volt_{gesamt}$ des Batteriesystems und der effektiven Gesamtspannung $Volt1_{gesamt}$ aller Batteriezellen, des zweiten Differenzwertes $Volt_{aus}$ zwischen der Gesamtspannung $Volt_{gesamt}$ des Batteriesystems und der effektiven Gesamtspannung $Volt1_{gesamt}$ aller Batteriezellen:

$$Volt_{aus} = Volt_{gesamt} - Volt1_{gesamt} = Volt_{gesamt} - \sum_{i=1}^{n} Zelle_i \qquad \text{Gleichung}$$

(1)

wenn ein Verhältnis des zweiten Differenzwertes $Volt_{aus}$ zur Zahl N größer oder gleich dem voreingestellten Differenzwert $Volt_{thr}$ ist:

$$\frac{Volt_{aus}}{N} \geq Volt_{thr} \quad \text{Gleichung} \quad (2),$$

Bestimmen, dass der aktuelle Rahmen ein Rahmen mit anormalen Spannungsdaten ist;
wobei in Gleichung (1) $Zelle_i$ eine Spannung der i-ten Batteriezelle und n eine Gesamtzahl der Batteriezellen ist.

5. Fehlerwarnverfahren für Batteriespannungserfassung nach Anspruch 3, wobei der Schritt "Berechnen (S300) einer Gesamtzahl von Rahmen in der voreingestellten Überwachungsdauer und Berechnen eines Verhältnisses der Anzahl von Rahmen mit anormalen Spannungsdaten zur Gesamtzahl von Rahmen, und wenn das Verhältnis größer oder gleich einem voreingestellten Verhältnisschwellenwert ist, Identifizieren einer anormalen Batteriezelle aus jeweiligen Batteriezellen" einen der folgenden Schritte umfasst:
Berechnen der Gesamtzahl von Rahmen innerhalb der voreingestellten Überwachungsdauer und Berechnen des Verhältnisses der Anzahl von Rahmen mit anormalen Spannungsdaten zur Gesamtzahl von Rahmen, und wenn das Verhältnis größer oder gleich dem voreingestellten Verhältnisschwellenwert ist, Bestimmen unter den jeweiligen Batteriezellen, dass eine Batteriezelle mit einer höchsten Anzahl an Vorkommen einer maximalen Mediandifferenz oder einer maximalen Durchschnittsdifferenz in einem einzelnen Rahmen innerhalb der voreingestellten Überwachungsdauer die anormale Batteriezelle ist.

6. Fehlerwarnverfahren für Batteriespannungserfassung nach Anspruch 1, wobei der Schritt "Erfassen (S100) einer effektiven Batteriezellenspannung jeder Batteriezelle" die folgenden Schritte umfasst:

Erfassen (S110) einer Anfangsspannung jeder Batteriezelle;

wenn die Anfangsspannung der Batteriezelle innerhalb eines voreingestellten Spannungsbereichs liegt, Nehmen (S120) der Anfangsspannung der Batteriezelle als effektive Batteriezellenspannung;

wenn die Anfangsspannung der Batteriezelle außerhalb des voreingestellten Spannungsbereichs liegt, Ausgeben (S130) des Abtastfehlerwarnsignals.

**7.** Fehlerwarnverfahren für Batteriespannungserfassung nach Anspruch 2, wobei der voreingestellte Differenzwert auf 0,2 V eingestellt wird und der voreingestellte Verhältnisschwellenwert auf 10 % eingestellt wird.

**8.** Fehlerwarnsystem für Batteriespannungserfassung (100), umfassend:

ein Spannungserfassungsmodul (110), das so konfiguriert ist, dass es innerhalb einer voreingestellten Überwachungsdauer in jedem Zeitrahmen eine Gesamtspannung eines Batteriesystems und eine effektive Batteriezellenspannung jeder Batteriezelle erfasst;

ein Modul zum Erfassen einer Anzahl von Rahmen mit Anomalien (120), das auf Kommunikationsweise mit dem Spannungserfassungsmodul (110) verbunden ist und so konfiguriert ist, dass es, basierend auf der voreingestellten Überwachungsdauer, der Gesamtspannung des Batteriesystems und der effektiven Spannung jeder Batteriezelle, eine Anzahl von Rahmen mit anormalen Spannungsdaten berechnet;

ein Modul für anormale Batteriezellen (130), das auf Kommunikationsweise mit dem Spannungserfassungsmodul (110) und dem Modul zum Erfassen einer Anzahl von Rahmen mit Anomalien (120) verbunden ist und so konfiguriert ist, dass es eine Gesamtzahl von Rahmen innerhalb der voreingestellten Überwachungsdauer berechnet und eine Verhältnis der Anzahl von Rahmen mit anormalen Spannungsdaten zur Gesamtzahl der Rahmen berechnet, und wenn das Verhältnis größer oder gleich einem voreingestellten Verhältnisschwellenwert ist, eine anormale Batteriezelle unter den jeweiligen Batteriezellen identifiziert und ein Abtastfehlerwarnsignal ausgibt.

**9.** Fehlerwarnsystem für Batteriespannungserfassung (100) nach Anspruch 8, wobei das Modul zum Erfassen einer Anzahl von Rahmen mit Anomalien (120) konfiguriert ist zum: Durchlaufen von jedem Rahmen innerhalb der voreingestellten Überwachungsdauer, Berechnen, basierend auf der effektiven Batteriezellenspannung im aktuellen Rahmen, eines Spannungsreferenzwert der Batteriezelle und Berechnen eines ersten Differenzwerts zwischen der effektiven Batteriezellenspannung jeder Batteriezelle und dem Spannungsreferenzwert und Zählen einer ersten Anzahl von Batteriezellen, deren erster Differenzwert größer ist als ein voreingestellter Differenzwert; Berechnen eines zweiten Differenzwerts zwischen der Gesamtspannung des Batteriesystems und einer effektiven Gesamtspannung aller Batteriezellen, und wenn ein Verhältnis des zweiten Differenzwerts zur ersten Anzahl größer oder gleich dem voreingestellten Differenzwert ist, Bestimmen, dass der aktuelle Rahmen ein Rahmen mit anormalen Spannungsdaten ist; Berechnen, basierend auf der voreingestellten Überwachungsdauer und dem Rahmen mit anormalen Spannungsdaten, der Anzahl von Rahmen mit anormalen Spannungsdaten.

**10.** Fehlerwarnsystem für Batteriespannungserfassung (100) nach Anspruch 9, wobei der erste Differenzwert eine Mediandifferenz oder einen Spannungsdurchschnitt umfasst und das Modul zum Erfassen einer Anzahl von Rahmen mit Anomalien (120) weiter konfiguriert ist zum:

Berechnen, basierend auf der jeweiligen effektiven Batteriezellenspannung im aktuellen Rahmen, einer Medianspannung aller effektiven Batteriezellenspannungen und Berechnen einer Mediandifferenz zwischen jeder effektiven Batteriezellenspannung und der Medianspannung und Zählen der ersten Anzahl von Batteriezellen, deren Mediandifferenz größer als der voreingestellte Differenzwert ist; oder

Berechnen, basierend auf der jeweiligen effektiven Batteriezellenspannung im aktuellen Rahmen, einer Durchschnittsspannung aller effektiven Batteriezellenspannungen und Berechnen einer Durchschnittsdifferenz zwischen jeder effektiven Batteriezellenspannung und der Durchschnittsspannung sowie Zählen der ersten Anzahl von Batteriezellen, deren Durchschnittsdifferenz größer als der voreingestellte Differenzwert ist.

**11.** Fehlerwarnsystem für Batteriespannungserfassung (100) nach Anspruch 10, wobei das Modul zum Erfassen einer Anzahl von Rahmen mit Anomalie (120) weiter konfiguriert ist zum:

Berechnen, basierend auf der Gesamtspannung $Volt_{gesamt}$ des Batteriesystems und der effektiven Gesamtspannung $Volt1_{gesamt}$ aller Batteriezellen, des zweiten Differenzwertes $Volt_{aus}$ zwischen der Gesamtspannung $Volt_{gesamt}$ des Batteriesystems und der effektiven Gesamtspannung $Volt1_{gesamt}$ aller Batteriezellen:

$$\text{Volt}_{\text{aus}} = \text{Volt}_{\text{gesamt}} - \text{Volt1}_{\text{gesamt}} = \text{Volt}_{\text{gesamt}} - \sum_{i=1}^{n} \text{Zelle}_i \qquad \text{Gleichung}$$

(1)

wenn ein Verhältnis des zweiten Differenzwertes $\text{Volt}_{\text{aus}}$ zur Zahl N größer oder gleich dem voreingestellten Differenzwert $\text{Volt}_{\text{thr}}$ ist:

$$\frac{\text{Volt}_{\text{aus}}}{N} \geq \text{Volt}_{\text{thr}} \quad \text{Gleichung} \quad (2),$$

Bestimmen, dass der aktuelle Rahmen ein Rahmen mit anormalen Spannungsdaten ist;
wobei in Gleichung (1) $\text{Zelle}_i$ eine Spannung der i-ten Batteriezelle und n eine Gesamtzahl der Batteriezellen ist.

12. Fehlerwarnsystem für Batteriespannungserfassung (100) nach Anspruch 10, wobei das Modul für anormale Batteriezellen (130) konfiguriert ist zum: Berechnen der Gesamtzahl von Rahmen in der voreingestellten Überwachungsdauer und Berechnen des Verhältnisses der Anzahl von Rahmen mit anormalen Spannungsdaten zur Gesamtzahl von Rahmen, und wenn das Verhältnis größer oder gleich dem voreingestellten Verhältnisschwellenwert ist, Bestimmen unter den jeweiligen Batteriezellen, dass eine Batteriezelle mit einer höchsten Anzahl von Auftreten einer maximalen Mediandifferenz oder einer maximalen Durchschnittsdifferenz in einem einzelnen Rahmen innerhalb der voreingestellten Überwachungsdauer die anormale Batteriezelle ist.

13. Fehlerwarnsystem für Batteriespannungserfassung (100) nach Anspruch 8, wobei das Spannungserfassungsmodul (110) weiter konfiguriert ist zum:

Erfassen einer Anfangsspannung jeder Batteriezelle;
wenn die Anfangsspannung der Batteriezelle innerhalb eines voreingestellten Spannungsbereichs liegt, Nehmen der Anfangsspannung der Batteriezelle als effektive Batteriezellenspannung;
wenn die Anfangsspannung der Batteriezelle außerhalb des voreingestellten Spannungsbereichs liegt, Ausgeben des Abtastfehlerwarnsignal.

14. Fehlerwarnsystem für Batteriespannungserfassung (100) nach Anspruch 9, wobei der voreingestellte Differenzwert auf 0,2 V eingestellt wird und der voreingestellte Verhältnisschwellenwert auf 10 % eingestellt wird.

15. Computerlesbares Speichermedium, das ein Computerprogramm speichert, das, wenn es von einem Prozessor ausgeführt wird, es dem Prozessor ermöglicht, das Verfahren nach einem der Ansprüche 1 bis 7 zu implementieren.

**Revendications**

1. Procédé d'avertissement de défaut d'acquisition de tension de batterie, comprenant les étapes de :

acquisition (S100), dans une durée de surveillance prédéfinie, d'une tension totale de système de batterie à chaque image et acquisition d'une tension efficace de cellule de batterie de chaque cellule de batterie ;
calcul (S200) d'un nombre d'images avec des données de tension anormales en fonction de la durée de surveillance prédéfinie, de la tension totale du système de batterie et de la tension effective de chaque cellule de batterie ;
calcul (S300) d'un nombre total d'images dans la durée de surveillance prédéfinie, et calcul d'un rapport du nombre d'images avec des données de tension anormales au nombre total d'images, et si le rapport est supérieur ou égal à un seuil de proportion prédéfini, identification d'une cellule de batterie anormale parmi les cellules de batterie respectives et émission d'un signal d'avertissement de défaut d'échantillonnage.

2. Procédé d'avertissement de défaut d'acquisition de tension de batterie selon la revendication 1, dans laquelle l'étape de « calcul (S200) d'un nombre d'images avec des données de tension anormales en fonction de la durée de surveillance prédéfinie, de la tension totale du système de batterie et de la tension effective de chaque cellule de batterie » comprend les étapes de :

traversée (S210) de chaque image pendant la durée de surveillance prédéfinie, calcul, sur la base de la tension effective de chaque cellule de batterie à une image donnée, d'une valeur de référence de tension de la cellule de batterie, et calcul d'une première valeur de différence entre la tension effective de chaque cellule de batterie et la valeur de référence de tension, comptage d'un premier nombre de cellules de batterie pour lesquelles cette première valeur de différence est supérieure à une valeur de différence prédéfinie ;

calcul (S220) d'une seconde valeur de différence entre la tension totale du système de batterie et la tension effective totale de toutes les cellules de batterie, et si un rapport de la seconde valeur de différence au premier nombre est supérieur ou égal à la valeur de différence prédéfinie, détermination que l'image actuelle est une image avec des données de tension anormales ;

calcul (S230), sur la base de la durée de surveillance prédéfinie et de l'image avec des données de tension anormales, du nombre d'images avec des données de tension anormales.

3. Procédé d'avertissement de défaut d'acquisition de tension de batterie selon la revendication 2, dans lequel la première valeur de différence comprend une différence médiane ou une moyenne de tension, et l'étape de « calcul (S210), sur la base de la tension effective de chaque cellule de batterie à une image de courant, d'une valeur de référence de tension de la cellule de batterie et calcul d'une première valeur de différence entre la tension effective de chaque cellule de batterie et la valeur de référence de tension, et comptage d'un premier nombre de cellules de batterie dont la première valeur de différence est supérieure à une valeur de différence prédéfinie » comprend une étape de :

calcul, à partir de la tension effective de chaque cellule de batterie à l'instant présent, d'une tension médiane de toutes les tensions effectives des cellules de batterie et calcul d'une différence médiane entre la tension effective de chaque cellule de batterie et la tension médiane, et comptage du premier nombre de cellules de batterie dont la différence médiane est supérieure à la valeur de différence prédéfinie ; ou

calcul, sur la base de la tension effective de chaque cellule de batterie à l'échelle actuelle, d'une tension moyenne de toutes les tensions effectives des cellules de batterie et calcul d'une différence moyenne entre la tension effective de chaque cellule de batterie et la tension moyenne, et comptage du premier nombre de cellules de batterie dont la différence moyenne est supérieure à la valeur de différence prédéfinie.

4. Procédé d'avertissement de défaut d'acquisition de tension de batterie selon la revendication 3, dans lequel l'étape de « calcul (S220) d'une seconde valeur de différence entre la tension totale du système de batterie et la tension effective totale de toutes les cellules de batterie, et si le rapport de la seconde valeur de différence au premier nombre est supérieur ou égal à la valeur de différence prédéfinie, détermination que l'image actuelle est une image avec des données de tension anormales » comprend les étapes de :

calcul, sur la base de la tension totale $Volt_{total}$ du système de batterie et de la tension effective totale $Volt1_{total}$ de toutes les cellules de batterie, de la seconde valeur de différence $volt_{off}$ entre la tension totale $Volt_{total}$ du système de batterie et la tension effective totale $Volt1_{total}$ de toutes les cellules de batterie :

$$volt_{off} = Volt_{total} - Volt1_{total} = Volt_{total} - \sum_{i=1}^{n} Cell_i \qquad \text{équation (1)}$$

si un rapport entre la seconde valeur de différence $volt_{off}$ et le premier nombre N est supérieur ou égal à la valeur de différence prédéfinie $volt_{thr}$ : $\frac{volt_{off}}{N} \geq volt_{thr}$ équation (2), détermination que l'image actuelle est une image avec des données de tension anormales ;

dans lequel l'équation (1), $Cell_i$ est une tension d'une i-ème cellule de batterie, et n est un nombre total de cellules de batterie.

5. Procédé d'avertissement de défaut d'acquisition de tension de batterie selon la revendication 3, dans lequel l'étape de « calcul (S300) d'un nombre total d'images dans la durée de surveillance prédéfinie, et calcul d'un rapport du nombre d'images avec des données de tension anormales au nombre total d'images, et si le rapport est supérieur ou égal à un seuil de proportion prédéfini, identification d'une cellule de batterie anormale parmi les cellules de batterie respectives et émission d'un signal d'avertissement de défaut d'échantillonnage » comprend une étape de :

calcul du nombre total d'images dans la durée de surveillance prédéfinie, et calcul du rapport entre le nombre d'images avec des données de tension anormales et le nombre total d'images, et si le rapport est supérieur ou égal au seuil de proportion prédéfini, détermination, à partir des cellules de batterie respectives, qu'une cellule de batterie, avec le nombre d'occurrences le plus élevé d'une différence médiane maximale ou d'une différence moyenne maximale sur une seule image dans la durée de surveillance prédéfinie, est la cellule de batterie anormale.

6. Procédé d'avertissement de défaut d'acquisition de tension de batterie selon la revendication 1, dans lequel l'étape « d'acquisition (5100) d'une tension effective de cellule de batterie » comprend les étapes de :

acquisition (5110) d'une tension initiale de chaque cellule de batterie ;
si la tension initiale de la cellule de batterie se situe dans une plage de tension prédéfinie, prise (S 120) de la tension initiale de la cellule de batterie comme tension effective de la cellule de batterie ;
si la tension initiale de la cellule de batterie est hors de la plage de tension prédéfinie, émission (S130) du signal d'avertissement de défaut d'échantillonnage.

7. Procédé d'avertissement de défaut d'acquisition de tension de batterie selon la revendication 2, dans laquelle la valeur de différence prédéfinie est fixée à 0,2 V et le seuil de proportion prédéfini est fixé à 10 %.

8. Système d'avertissement de défaut pour l'acquisition de la tension de batterie (100), comprenant :

un module d'acquisition de tension (110), configuré pour acquérir, dans une durée de surveillance prédéfinie, une tension totale d'un système de batterie à chaque image de temps et acquérir une tension effective de cellule de batterie de chaque cellule de batterie ;
un module pour acquérir un certain nombre d'images avec anomalie (120), connecté au module d'acquisition de tension (110) de manière à communiquer et configuré pour calculer un nombre d'images avec des données de tension anormales en fonction de la durée de surveillance prédéfinie, de la tension totale du système de batterie et de la tension effective de chaque cellule de batterie ;
un module de cellule de batterie anormale (130), connecté de manière à communiquer avec le module d'acquisition de tension (110) et le module d'acquisition d'un nombre d'images avec anomalie (120), et configuré pour : calculer un nombre total d'images dans la durée de surveillance prédéfinie, et calculer un rapport du nombre d'images avec des données de tension anormales au nombre total d'images, et si le rapport est supérieur ou égal à un seuil de proportion prédéfini, identifier une cellule de batterie anormale parmi les cellules de batterie respectives et émettre un signal d'avertissement de défaut d'échantillonnage.

9. Système d'alerte de défaut pour l'acquisition de la tension de batterie (100) selon la revendication 8, dans lequel le module d'acquisition du nombre d'images présentant une anomalie (120) est configuré pour : parcourir chaque image pendant la durée de surveillance prédéfinie ; calculer, à partir de la tension effective de chaque cellule de batterie à l'image courante, une valeur de référence de tension de la cellule et calculer une première différence entre la tension effective de chaque cellule et la valeur de référence ; compter un premier nombre de cellules pour lesquelles cette première différence est supérieure à une différence prédéfinie ; calculer une seconde différence entre la tension totale du système de batterie et la tension effective totale de toutes les cellules ; si le rapport entre cette seconde différence et la première est supérieur ou égal à la différence prédéfinie, déterminer que l'image courante présente des données de tension anormales ; calculer, à partir de la durée de surveillance prédéfinie et de l'image présentant des données de tension anormales, le nombre d'images présentant des données de tension anormales.

10. Système d'avertissement de défaut d'acquisition de tension de batterie (100) selon la revendication 9, dans lequel la première valeur de différence comprend une différence médiane ou une moyenne de tension, et le module d'acquisition d'un certain nombre d'images présentant une anomalie (120) est en outre configuré pour :

calculer, à partir de la tension effective de chaque cellule de batterie à l'instant présent, une tension médiane de toutes les tensions effectives des cellules de batterie et calculer une différence médiane entre la tension effective de chaque cellule de batterie et la tension médiane, et compter le premier nombre de cellules de batterie dont la différence médiane est supérieure à la valeur de différence prédéfinie ; ou
calculer, sur la base de la tension effective de chaque cellule de batterie à l'échelle actuelle, une tension moyenne de toutes les tensions effectives des cellules de batterie et calculer une différence moyenne entre la tension effective de chaque cellule de batterie et la tension moyenne, et compter le premier nombre de cellules de batterie dont la différence moyenne est supérieure à la valeur de différence prédéfinie.

11. Système d'avertissement de défaut d'acquisition de tension de batterie (100) selon la revendication 10, dans lequel le module d'acquisition d'un certain nombre d'images présentant une anomalie (120) est en outre configuré pour :

calculer, sur la base de la tension totale $Volt_{total}$ du système de batterie et de la tension effective totale $Volt1_{total}$ de

toutes les cellules de batterie, de la seconde valeur de différence $volt_{off}$ entre la tension totale $Volttotal$ du système de batterie et la tension effective totale $Volt1_{total}$ de toutes les cellules de batterie :

$$volt_{off} = Volt_{total} - Volt1_{total} = Volt_{total} - \sum_{i\,=\,1}^{n} Cell_i \qquad \text{équation (1)}$$

si le rapport entre la seconde valeur de différence $volt_{off}$ et le premier nombre N est supérieur ou égal à la valeur de différence prédéfinie$volt_{thr}$ : $\dfrac{volt_{off}}{N} \geq volt_{thr}$ équation (2), déterminer que l'image actuelle est une image avec des données de tension anormales ;

dans lequel l'équation (1), $Cell_i$ est une tension d'une i-ème cellule de batterie, et n est un nombre total de cellules de batterie.

**12.** Système d'avertissement de défaut pour l'acquisition de tension de batterie (100) selon la revendication 10, dans lequel le module de cellule de batterie anormale (130) est configuré pour : calculer le nombre total d'images dans la durée de surveillance prédéfinie, et calculer le rapport du nombre d'images avec des données de tension anormales au nombre total d'images, et si le rapport est supérieur ou égal au seuil de proportion prédéfini, déterminer, à partir des cellules de batterie respectives, qu'une cellule de batterie, avec un nombre d'occurrences le plus élevé d'une différence médiane maximale ou d'une différence moyenne maximale sur une seule image de temps dans la durée de surveillance prédéfinie, est la cellule de batterie anormale.

**13.** Système d'avertissement de défaut pour l'acquisition de tension de batterie (100) selon la revendication 8, dans lequel le module d'acquisition de tension (110) est en outre configuré pour :

acquérir une tension initiale de chaque cellule de batterie ;
si la tension initiale de la cellule de batterie se situe dans une plage de tension prédéfinie, prendre la tension initiale de la cellule de batterie comme tension effective de la cellule de batterie ;
si la tension initiale de la cellule de batterie est hors de la plage de tension prédéfinie, émettre le signal d'avertissement de défaut d'échantillonnage.

**14.** Système d'avertissement de défaut d'acquisition de tension de batterie (100) selon la revendication 9, dans laquelle la valeur de différence prédéfinie est fixée à 0,2 V et le seuil de proportion prédéfini est fixé à 10 %.

**15.** Support de stockage lisible par ordinateur, stockant un programme informatique qui, lorsqu'il est exécuté par un processeur, permet au processeur de mettre en œuvre le procédé selon l'une quelconque des revendications 1 à 7.

| Acquiring, within a preset monitoring duration, a total voltage of a battery system at each frame of time and acquiring an effective battery cell voltage of each battery cell | S100 |

| Calculating a number of frames with abnormal voltage data based on the preset monitoring duration, the total voltage of the battery system and each effective battery cell voltage | S200 |

| Calculating a total number of frames in the preset monitoring duration, and calculating a ratio of the number of frames with abnormal voltage data to the total number of frames, and if the ratio is greater than or equal to a preset proportion threshold, identifying an abnormal battery cell from respective battery cells and issuing a sampling fault warning signal | S300 |

FIG. 1

| Traversing each frame within the preset monitoring duration, calculating, based on each effective battery cell voltage at a current frame, a voltage reference value of the battery cell and calculating a first difference value between each effective battery cell voltage and the voltage reference value, and counting a first number of battery cells with the first difference value being greater than a preset difference value | S210 |

| Calculating a second difference value between the total voltage of the battery system and a total effective voltage of all battery cells, and if a ratio of the second difference value to the first number is greater than or equal to the preset difference value, determining that the current frame is a frame with abnormal voltage data | S220 |

| Calculating, based on the preset monitoring duration and the frame with abnormal voltage data, the number of frames with abnormal voltage data | S230 |

FIG. 2

17

Acquiring an initial voltage of each battery cell — S110

If the initial voltage of the battery cell is within a preset voltage range, taking the initial voltage of the battery cell as the effective battery cell voltage — S120

If the initial voltage of the battery cell is out of the preset voltage range, issuing the sampling fault warning signal — S130

FIG. 3

Fault warning system for battery voltage acquisition 100

Voltage acquisition module 110

Module for acquiring a number of frames with abnormality 120

Abnormal battery cell module 130

FIG. 4

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202211056283
- CN 108931725 A